# EUROPEAN PATENT SPECIFICATION

(11) **EP 3 683 914 B1**
(45) Date of publication and mention of the grant of the patent: **06.03.2024**
(21) Application number: 19152476.8
(22) Date of filing: 18.01.2019
(51) Int. Cl.: H02J 7/00, H05K 1/02

(54) **CIRCUIT CARRIER FOR A BATTERY SYSTEM AND BATTERY SYSTEM**
SCHALTUNGSTRÄGER FÜR EIN BATTERIESYSTEM SOWIE BATTERIESYSTEM
SUPPORT DE CIRCUIT POUR SYSTÈME DE BATTERIE ET SYSTÈME DE BATTERIE

(43) Date of publication of application: 22.07.2020
(73) Proprietor: Samsung SDI Co., Ltd., Gyeonggi-do 17084 (KR)
(72) Inventor: Korherr, Thomas, 8230 Hartberg (AT); Kurcik, Peter, 8505 St. Nikolai im Sausal (AT); Weissensteiner, Birgit, 8010 Graz (AT)
(74) Representative: Gulde & Partner

(56) References cited:
- WO-A1-2014/120688
- DE-A1-102010 039 277
- US-A- 5 495 076
- US-A1- 2013 302 651
- US-A1- 2014 003 016
- US-A1- 2016 150 636

## Description

### Field of the Invention

The present invention relates to a circuit carrier for a battery system, preferably to a cell supervision circuit carrier or a battery management system circuit carrier. The invention further relates to a battery system comprising at least one such a circuit carrier, preferably in combination with at least one shunt resistor for current sensing on the battery system.

### Technological Background

A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for electric or hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose.

Rechargeable batteries may be used as a battery module formed of a plurality of unit battery cells coupled in series and/or in parallel so as to provide a high energy density, e.g. for motor driving of a hybrid vehicle. That is, the battery module is formed by interconnecting the electrode terminals of the plurality of unit battery cells depending on a required amount of power and in order to realize a high-power rechargeable battery, e.g. for an electric vehicle.

Battery modules can be constructed either in block design or in modular design. In block designs, each battery cell is coupled to a common current collector structure and a common battery management system. In modular designs, pluralities of battery cells are connected to form submodules and several submodules are connected to form the battery module. Battery management functions may be realized either on module or submodule level and thus interchangeability of the components is improved. One or more battery modules are mechanically and electrically integrated, equipped with a thermal management system and set up for communication with one or more electric consumers for forming a battery system.

To provide thermal control of a battery system a thermal management system is required to safely use the at least one battery module by efficiently emitting, discharging and/or dissipating heat generated from its rechargeable batteries. If the heat emission/discharge/dissipation is not sufficiently performed, temperature deviations occur between respective battery cells, such that the at least one battery module cannot generate a desired amount of power. In addition, an increase of the internal temperature can lead to abnormal reactions occurring therein and thus charging and discharging performance of the rechargeable battery deteriorates and the life-span of the rechargeable battery is shortened. Thus, cooling devices for effectively emitting/discharging/dissipating heat from the cells is required.

For meeting the dynamic power demands of various electrical consumers connected to the battery system a static control of the battery power output and charging is not sufficient. Thus, steady exchange of information between the battery system and the controllers of the electrical consumers is required. This information includes the battery systems actual state of charge (SoC), potential electrical performance, charging ability and internal resistance as well as actual or predicted power demands or surpluses of the consumers. Battery systems usually comprise a battery management system (BMS) for processing this information.

The BMS is usually coupled to the controller of one or more electrical consumers as well as to each of the battery modules of the battery system. For controlling a plurality of battery modules by a single BMS, a daisy chain setup may be used. In such setup, the BMS, as master, is connected for communication in series to a plurality of battery modules, particularly to a plurality of cell supervision circuits, CSC, of the respective battery modules. Daisy chain setups as well as corresponding protocols are commonly used in the art.

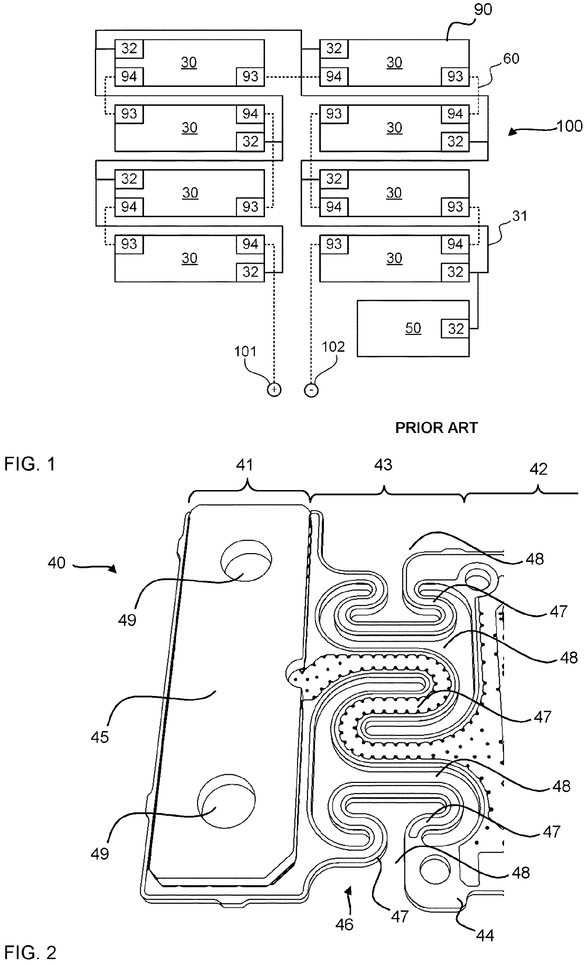

An exemplary battery system 100 with a daisy chain setup according to the prior art is illustrated in Figure 1. Therein, a BMS 50 is setup for communication with a plurality of battery modules 90, each comprising a cell supervision circuit carrier 30 according to the prior art. Such a cell supervision circuit carrier 30 comprises a negative module terminal 93 and a positive module terminal 94. A negative module terminal 93 of a first battery module is electrically connected to a negative system terminal 102 via a busbar 60. The positive system terminal 94 of that first battery module is connected to the negative module terminal 93 of a subsequent battery module 90 via a busbar 60 as well. The positive module terminal 94 of a last battery module is connected to a positive system terminal 101 for setting up the power connection.

For setting up a communication connection between the battery modules 90 and a BMS 50, each cell supervision circuit carrier 30 further comprises a connector 32 for setting up a daisy chain. The connector 32 serves as input/output for communication between the BMS 50 and the CSCs of the modules. One wiring harness 31 connects a connector 32 of the BMS 50 with the connectors 32 of all cell supervision circuit carriers 30. Alternatively to the prior art battery system 100 shown in Figure 1, a daisy chain optimized layout could be used. Also, other different PCB designs could be used for the cell supervision circuit carriers 30.

The cell supervision circuit carriers 30, as exemplarily shown in Figure 1, usually further comprise at least one shunt resistor for performing shunt based current sensing. Therein, the current sensing may be performed with respect to at least one busbar 60 interconnecting adjacent battery modules or with respect to at least one busbar interconnecting terminals of battery cells within a single battery module. The integration of such shunt resistor on the cell supervision circuit carrier is often realized by soldering the shunt directly on the printed circuit board, PCB, alongside with the signal conditioning and measurement circuitry. In 48 V batteries, the shunt resistor might even be soldered to a PCB comprising the whole BMS.

According to the prior art, as the shunt resistor is mounted to the printed circuit board, e.g., of a CSC or a BMS, a rigid connection is created between the shunt and the PCB. While installing such PCB in a battery system, the PCB is further rigidly fixed to the battery housing, while the shunt becomes connected to at least one bus bar. These connections between the PCB and the housing and the shunt and the bus bar may transfer mechanical stress, e.g., by bending or flexing, to the PCB, particularly as the PCB is often mechanically weaker than the connected housing and bus bars. Additionally, mechanical stress may arise during operation of the PCB, if dimensional changes of the battery cells or the housing, e.g. due to temperature changes, cell swelling, aging, etc., differ from dimensional changes of the PCB. Mechanical stress may further arise during assembly of the components, such as e.g., connecting (screwing) the shunt to the bus bar. The printed circuit boards of a CSC or a BMS usually contain additional mechanically sensitive components like ceramic capacitors or quartz crystals. These components can be damaged by the application of such mechanical stress to the PCB.

A battery pack with first circuit boards connected to a second circuit board via connection wires is disclosed in US 2013/302651 A1. A circuit board circuit board with planar sections for attaching electrical components and spring sections that provide flexibility between the planar sections is disclosed in US 5495076 A. Further prior art circuit boards that can be used in prior art battery systems are disclosed in US 2016/160636 A1, DE 102010039277 A1, US 2014/003016 A1, and WO 2014/120688 A1.

It is thus an object of the present invention to overcome or reduce at least some of the drawbacks of the prior art and to provide a circuit carrier for a battery system control unit that allows for reducing mechanical stress applied to the sensitive components mounted thereto.

### Summary of Invention

One or more of the drawbacks of the prior art could be avoided or at least reduced by means of the present invention. In particular, a battery cell supervision circuit carrier is provided in accordance with the appended claims and as described in the following.

The circuit carrier is configured to be mounted to a battery system, e.g. on battery, submodule, module, or system level. In other words, the circuit carrier is configured to host a control unit for a battery system, wherein the control unit comprises multiple components mounted, e.g. surface mounted, to the circuit carrier. As a central part, the circuit carrier comprises a circuit carrier board that forms the mechanical backbone of the circuit carrier. The circuit carrier may further comprise components such as e.g., a wire frame, wires, insulating or conductive surface coatings and packaging materials. The circuit carrier board preferably is a printed circuit board (PCB) or any other suitable substrate.

The circuit carrier board has a first region and a second region, wherein a shunt resistor is surface mounted in the first region and wherein the second region is configured to receive further electronic components. Preferably, the circuit carrier board is plate-shaped, i.e. is of cuboid shape with a length and a width significantly exceeding the height. Then, the first region and the second region are preferably separated along the length direction and/or along the width direction. In a preferred embodiment, the circuit carrier board is configured to receive surface mounted devices, SMD, and the first region is a first surface region of a first main surface or a second main surface opposite the first main surface and the second region is a second surface region of the same main surface as the first surface region.

According to the present invention, the first region and the second region are separated from each other by a third region that is configured for forming a flexible connection between the first region and the second region. In other words, the third region is disposed in between the first region and the second region, preferably along the width direction and/or the length direction of a cuboid circuit carrier board. According to the present invention, the third region comprises a spring-like structure that is formed from the circuit carrier board. Therein, the spring-like structure is configured to provide an elastic connection between the first region and the second region, i.e. to deform under tension, torsion and/or compression applied to at least one of the first region, second region, or third region. Further, the spring-like structure is formed from the circuit carrier board, i.e. of the material from the circuit carrier board. Preferably, the spring-like structure is formed from the circuit carrier board by removing material therefrom, e.g. by milling. Therein, the material is preferably removed such that at least one through-opening is formed in the third region, i.e. that the circuit carrier board is partially removed in the third region. Further, the remainder of the circuit carrier board is preferably shaped for providing a spring-like characteristic, i.e. as a planar spring. In other words, within the third region the circuit carrier board is configured, i.e. formed, as a planar spring.

The circuit carrier according to the present invention advantageously allows for mechanically decoupling a first region and a second region of a circuit carrier board. As the circuit carrier is configured to be mounted to a battery system, e.g. by connecting the first region or the second region to the battery system, the other region remains mechanically uncoupled from the battery system to a certain extent. Hence, mechanical impacts or vibrations transferred to the region connected to the battery system during installation of the circuit carrier to the battery system or the operation of the battery system are damped and/or less strongly transmitted to the other region. Further, any other impacts on one region, i.e. while surface mounting a component, such as the shunt resistor, thereto, are damped and/or less strongly transmitted to the other region. In other words, the third region advantageously allows for compensating dimensional changes of the circuit carrier and/or the battery system without stressing of the components installed thereon. Advantageously, the circuit carrier of the invention allows decoupling the shunt resistor that is surface mounted to the first region from further electronic components that are (surface) mounted to the second region.

As described above, the circuit carrier is configured to be mounted to a battery system, preferably by providing a mechanical connection to the battery system. The mechanical connection is preferably provided between the circuit carrier board and a battery cell, submodule, or module or a housing of the battery system. In other words, the circuit carrier board is configured for being mounted to the battery system or parts thereof. Further preferred, an electric connection is formed between the circuit carrier and the battery system, e.g. for measuring voltages and/or currents of the battery system and/or to transmit signals to the battery system. Particularly preferred, the electrical connection is provided by mounting a shunt resistor to a first region of the circuit carrier board and electrically connecting the shunt resistor to a current path of the battery system. Therein, the shunt resistor may be connected to a busbar connecting terminals of two battery cells or modules of the battery system. Further preferred, the shunt resistor may form at least a part of such busbar itself. Also preferred, conducting lines and/or conductive pads are disposed on the circuit carrier board.

Any electrical connections or interconnections described herein may be realized by wires or conducting elements, e.g. on a PCB or another kind of circuit carrier. The conducting elements may comprise metallization, e.g. surface metallization, and/or pins, and/or may comprise conductive polymers or ceramics. Further electrical energy might be transmitted via wireless connections, e.g. using electromagnetic radiation and/or light. Exemplarily, the second region that is configured to receive further electronic components comprises at least one landing pad, contact pad, chip socket, or the like and further comprises at least one electrical connection or interconnection for connecting the electronic components mounted or connect to this landing pads, contact pads, or chip sockets. However, electric connections between components connected to the second region may also be provided by wire bonds.

In a preferred embodiment of the present invention, the spring-like structure in the third region of the circuit carrier comprises at least one meander-shaped structure. Therein, the meander-shaped structure connects the first region and the second region, i.e., preferably comprises a first section that is continuous with the first region and a second section that is continuous with the second region. Further preferred, the remaining material of the third region, i.e., the material of the circuit carrier board is removed within the third region except for the meander-shaped structure. According to the present invention, a meander-shaped structure comprises a structure, preferably a continuous planar structure, which has at least one change of direction, preferably with a plurality of changes of direction. In a planar structure that means that a meander-shaped structure can be divided in at least two substantial parts (i.e. no infinitesimal parts or the like) that extend in different directions, wherein these substantial parts are connected to form the meander-shaped structure. Exemplarily, a meander shaped structure may comprise multiple substantial parts that are substantially parallel and that are connected to each other to form a continuous meander-shaped structure. Also, a meander-shaped structure may be essentially Q-shaped, with a first free end of the Q being the first section described above and a second free end of the Ω being the second section described above. However, various other meander-shaped structures are possible and can be utilized for achieving the advantages of the invention.

Particularly preferred, the spring-like structure of the circuit carrier of the invention comprises a plurality of meander-shaped structures, preferably a plurality of meander-shaped structures as described above, which are separated from each other by at least one through-opening. Therein, the material of the circuit carrier board is completely removed in a part thereof to form a through-opening of the circuit carrier board. However, a through-opening must not be enclosed by the circuit carrier board but may also be located at an edge of the circuit carrier board, i.e. form part of an edge region of the circuit carrier board. Further, each of the separated meander-shaped structures is connected to each of the first region and the second region, e.g., by comprising a first section that is continuous with the first region and a second section that is continuous with the second region. In this preferred embodiment, the third region consists of the meander-shaped structures and the through openings. That is, the third region of the circuit carrier board is fully segmented into the structures and openings.

According to a particularly preferred embodiment, the at least one spring-like structure, and further preferred the at least one meander-shaped structure, are formed by milling. Advantageously, the cost impact on the circuit carrier of this embodiment is minimal. Particularly, no additional production steps may be needed in the manufacturing of circuit carrier board, since the milling process might be used to create the outer contour of the circuit carrier board. Then, milling of the meander-shaped structure only slightly increases the milling process time and thus the manufacturing process time. However, in principal also other methods may be used for forming the spring-like structure, preferably the meander-shaped structure, such as e.g. laser cutting, waterjet cutting, or other material removing techniques. Also, the circuit carrier board already comprising the at least one spring-like structure, and further preferred the at least one meander-shaped structure, may be originally formed, e.g. casted, injection molded, and/or laminated or the like. In other words, the present invention also relates to a method for manufacturing a circuit carrier with a first region and a second region and a third region separating the first region and the second region and comprising a spring-like, e.g. meander-shaped, structure as described above.

The cell supervision circuit carrier preferably comprises a circuit carrier board as described above and having a first lateral edge and a second lateral edge that is opposite to the first lateral edge. In other words, the circuit carrier board has an essential rectangular shape that is preferably adapted to the dimensions of an essential rectangular battery module to which the circuit carrier board is or shall be mounted. Further preferred, such cell supervision circuit carrier further comprises busbar elements for electrically interconnecting the battery cells of the battery module in series and/or in parallel and at least one shunt resistor connected to such busbar. Also preferred, the shunt resistor of the cell supervision circuit carrier is configured to electrically interconnect battery cells of the battery module. Additionally or alternatively, the battery modules may comprise busbars that provide a power connection between different battery cells or different battery modules.

Further preferred, the battery system may comprise a plurality of busbars for electrically interconnecting battery modules and/or a plurality of busbar elements for electrically interconnecting battery cells of the battery system or battery modules. The busbars are preferably made of an electrically conductive material, e.g. aluminum, and preferably have a strip-like shape with a uniform busbar width and a uniform busbar height. However, the shape of the busbars may be freely adapted to meet individual requirements of a specific battery design, e.g. in view of a limited installation space. In particular, the busbar can be in the form of straight, bend or arbitrary curved belts, bands, ribbons, ribs or rails. Further, the busbar elements may be configured similarly to the busbars. According to this embodiment, the shunt resistor may be configured to be connected to a busbar or a busbar element.

According to a further preferred embodiment of the invention, the further electronic components that are or shall be mounted to and/or formed in the second region comprise a voltage measurement circuit that is configured to be connected to the shunt resistor. As commonly known, a shunt is used to measure a current between two nodes by drawing a current between these nodes across the shunt and by measuring a voltage drop over the shunt. In order to derive the current from the measured voltage, the ohmic resistance of the shunt has to be known. The voltage measurement circuit that is or shall be disposed in the second region is configured to allow for such current measurement via a shunt by realizing the voltage measurement and eventually by already determining the shunt current. Above that, the further electronics that are or shall be mounted to and/or formed in the second region are configured to provide further functions of a CSC or a BMS as described above.

In another preferred embodiment, at least one voltage path is provided between the first region and the second region. Further preferred, the at least one voltage path is formed in the third region, particularly preferred on or in the spring-like structure, preferably in or on at least one of the at least one meander-shaped structure. Particularly preferred, one meander-shaped structure between the first and second region serves for carrying the voltage path, wherein other meander-shaped structures serve solely for mechanically strengthening the connection between the first and second region. The at least one voltage path according to this embodiment is preferably configured for electrically connecting the shunt resistor and the voltage measurement circuit, i.e. to provide the voltage drop over the shunt to the voltage measurement circuit. In order to provide the voltage drop to the voltage measurement circuit, the voltage path thus preferably provides at least a first and a second conductive path connecting the shunt resistance and the voltage measurement circuit. However, for providing redundant signals to the voltage measurement circuit additional voltage paths are required.

According to the present invention, the at least one voltage path is enclosed by electrical shielding means. Therein, the electrical shielding means are preferably enclosing the at least one voltage path, preferably in a lateral direction and in a thickness direction of the preferably plate-shaped circuit board. The electrical shielding means commonly comprise conductive and/or magnetic materials. In such material a field opposite to external fields is formed that stops or limits external fields from penetrating there through. The electrical shielding means are electrically isolated from the at least one voltage path. Electrical shielding is essential in shunt current measurement, as the voltage levels measured across the shunt can be as low as a few microvolts and as electromagnetic interference levels present in the automotive environment could thus greatly decrease the measurement accuracy. Hence, by using electric shielding means, accurate voltage measurement is enabled.

According to the present invention, the circuit carrier board is a multi-layer circuit carrier comprising at least three electrically isolated carrier layers. Multiple layer circuit carriers, such as e.g. multi-layer PCBs, are known to the skilled person. The circuit carrier board of this embodiment requires at least three layers for providing at least one central voltage path layer that is enclosed via at least two outer layers that can be utilized for shielding the voltage path. However, if a redundant voltage path is desired between the shunt and the voltage measurement circuit, at least four electrically isolated layers are required in the circuit carrier.

According to the present invention, at least a first shunt contact pad and a second shunt contact pad that is separate from the first shunt contact pad are disposed in or on the first region. Further, these shunt contact pads are configured to be electrically connected to the shunt resistor. The first shunt contact pad is connected to a first conductive path disposed in an inner carrier layer of the multi carrier layer circuit carrier board and the second shunt contact pad is connected to a second conductive path disposed in the same or another inner carrier layer of the multi carrier layer circuit carrier board. In other words, at least one inner carrier layer comprises a first conductive path configured to be connected to the first shunt contact pad and a second conductive path configured to be connected to the second shunt contact pad. Therein, the first conductive path and second conductive path are preferably configured to be connected to the voltage measurement circuit. In order to provide a redundant voltage measurement signal at least a third and fourth conductive paths are required. The third and fourth conductive paths may be disposed on the same or another inner carrier layer of the multi carrier layer circuit carrier board as the first and second conductive paths.

Further, at least two outer carrier layers, i.e. carrier layers enclosing the at least one inner carrier layer in a thickness direction of the circuit carrier board, comprise a metallization within the third region. Therein, this metallizations is preferably disposed above and below the conductive paths of the inner carrier layer(s), i.e. in the thickness direction of the circuit carrier board. Further preferred, the metallization, e.g. the metallization layers disposed on the at least two outer carrier layers, respectively, further extends laterally, i.e. in a direction opposite to a thickness or normal direction of the circuit carrier board and perpendicular to an extension direction of the conductive paths, over the conductive paths on the at least one inner carrier layer. The metallization layers disposed on the at least two outer carrier layers, respectively, are electrically connected via a plurality of through hole vias, i.e. vias filled with an electrically conductive material. Particularly preferred, the vias connect the parts of the metallization layers that extend laterally over the conductive paths on the inner layer(s). These vias advantageously provide a lateral electric shielding of the conductive paths on the inner layer, wherein the metallizations advantageously provide an electric shielding in said thickness direction.

Another aspect of the present invention relates to a battery system comprising a circuit carrier according to the invention as described above. Therein, the shunt resistor is electrically connected to at least one current path of the battery system. Preferably, the battery system further comprises a first system terminal and a second system terminal, and a plurality of battery cells connected in series between the first system terminal and the second system terminal. The battery system may also comprise a plurality of battery modules connected in series between the first system terminal and the second system terminal. Then, each battery module comprises a plurality of battery cells that are electrically interconnected in series and/or in parallel between a negative module terminal and a positive module terminal. Further, preferred each of the plurality of battery modules comprises a cell supervision circuit carrier as described above as well as a cell supervision circuit, CSC, mounted to or formed in or on the respective cell supervision circuit carriers. The battery system may also comprise a battery management system, BMS, with a battery management system circuit carrier as described above.

Preferably, the battery system further comprises a plurality of busbars, wherein each busbar interconnects a positive module terminal of a first battery or battery module and a negative module terminal of a second battery or battery module. However, the busbars may also connect a first terminal of a first battery cell and a second terminal of a second battery cell. If the battery system comprises battery modules connected via busbars, the battery cells of the modules may be electrically interconnected in series and/or in parallel between the module terminals of the respective battery module via busbar elements. Therein, the busbar elements may constitute a part of the cell supervision circuit carrier or may be configured similarly to the busbars. The shunt resistor disposed in the first region of the circuit carrier board may at the same time be at least part of a busbar or a busbar element. In other words, the shunt resistor may form part of a current path of the battery system. The busbars may be made of an electrically conductive material, e.g. aluminum, and have a strip-like shape with a uniform busbar width and a uniform busbar height. However, the shape of the busbars may be freely adapted to meet individual requirements of a specific battery design, e.g. in view of a limited installation space. In particular, the busbar can be in the form of straight, bend or arbitrary curved belts, bands, ribbons, ribs or rails. The busbar elements may be configured as metallization that is disposed on the circuit carrier board of the cell supervision circuit carrier or may comprise any kind of wire, cable, metallization or an electrically conducting polymer. Alternatively, the busbar elements may be configured similarly to the busbars.

Further aspects of the present invention are disclosed in the dependent claims and in the following description.

### Brief Description of the Drawings

Features will become apparent to those of ordinary skill in the art by describing in detail exemplary embodiments with reference to the attached drawings in which:
- Fig. 1: illustrates a schematic top view of a battery system according to the prior art;
- Fig. 2: illustrates a schematic perspective view of a circuit carrier according to an embodiment;
- Fig. 3: illustrates a schematic perspective transparent view of a circuit carrier according to the embodiment of Figure 2;
- Fig. 4: schematically illustrates the layer structure of a circuit carrier, particularly a meander-shaped structure, according to an embodiment;
- Fig. 5: schematically illustrates another view of the layer structure of a circuit carrier, particularly the meander-shaped structure, according to an embodiment;
- Fig.6: illustrates a schematic perspective view of a circuit carrier according to an embodiment with an exposed first carrier layer;
- Fig.7: illustrates a schematic perspective view of a circuit carrier according to an embodiment with an exposed third carrier layer;
- Fig.8: illustrates a schematic perspective view of a circuit carrier according to an embodiment with an exposed fourth carrier layer; and
- Fig.9: illustrates a schematic perspective view of a circuit carrier according to an embodiment with an exposed sixth carrier layer.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes and elements not considered necessary to those having ordinary skill in the art for a complete understanding of the aspects and features of the present invention may not be described. In the drawings, the relative sizes of elements, layers, and regions may be exaggerated for clarity.

As used herein, the term "and/or" includes any and all combinations of one or more of the associated listed items. Further, the use of "may" when describing embodiments of the present invention refers to "one or more embodiments of the present invention." In the following description of embodiments of the present invention, the terms of a singular form may include plural forms unless the context clearly indicates otherwise. It is understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the invention. Expressions as "at least one of," when preceding a list of elements, modify the entire list of elements and do not modify the individual elements thereof.

As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed numerically it denotes a range of +/- 5% of the value centered thereon.

The battery system 100 according to the prior art as illustrated in Figure 1 has already been described in the introductory part of the present application. As already mentioned there, the battery system comprises a plurality of battery modules 90, each with a cell supervision circuit, CSC, 30, wherein each of the CSCs 30 is connected to a single BMS 50. The circuit carrier as described in the following may be used either for the CSC 30 or the BMS 50.

Figure 2 illustrates a circuit carrier 40 according to a first embodiment of the invention. Therein, the circuit carrier 40 comprises a circuit carrier board 44 and may further comprise other components (not shown) such as e.g., a wire-frame, packaging materials, or the like. The circuit carrier board 44 is a multilayer PCB as described in more detail in the following and comprises a first region 41, a second region 42, and a third region 43, wherein only a part of the second region 42 is shown in Figure 2. The first region 41 is configured to receive a shunt resistor 45 that is mounted to a surface of the first region 41. The shunt resistor 45 is configured to be connected to a current path of a battery system 100 as exemplarily shown in Figure 1. The shunt resistor 45 as shown in Figure 2 is configured to be used as a busbar 60 or as a busbar element as described above. Therefore, the first region 41 and the shunt resistor 45 each comprise two aligned terminal openings 49 that are configured to receive cell terminals of battery cells connected via the shunt resistor (busbar element) 45 or to receive module terminals connected via the shunt resistor (busbar) 45. The second region 42 of the circuit carrier 40 is configured to receive further electronic components, wherein the type, amount and connections of these further electronics depend, at least partially, on the intended purpose of the circuit carrier 40, e.g., as cell supervising circuit, CSC, carrier and/or battery management system, BMS, circuit carrier. The further electronic components preferably comprise at least one circuit, e.g. a voltage measurement circuit, or circuit component configured to be connected to the shunt resistor 45 as described in detail below.

The third region 43 of the circuit carrier 40 is configured as a spring-like element 46 and therefore comprises three meander-shaped structures 47 that are separated from each other by through-openings 48. Further through-openings 48 are disposed between the outermost meander-shapes structures 47 and form part of an edge-region of the circuit carrier 40. The meander-shaped structures 47 are formed by milling the through-openings 48 into the third region 43 by removing the remaining material of the circuit carrier board 44 in the third region 43. Each of the meander-shaped structures 47 is formed by an elongated portion of circuit carrier board 44 material that comprises multiple changes of direction. Further, the dimensions of the meander-shaped structures 47 are such that each of these sections comprises a sufficient elasticity for mechanically decoupling the first region 41 and the second region 42 of the circuit carrier board 44. Therein, these dimensions also depend on the material and the thickness of the circuit carrier board 44 and eventual packaging materials connected thereto and can be found by the skilled person without undue experimentation.

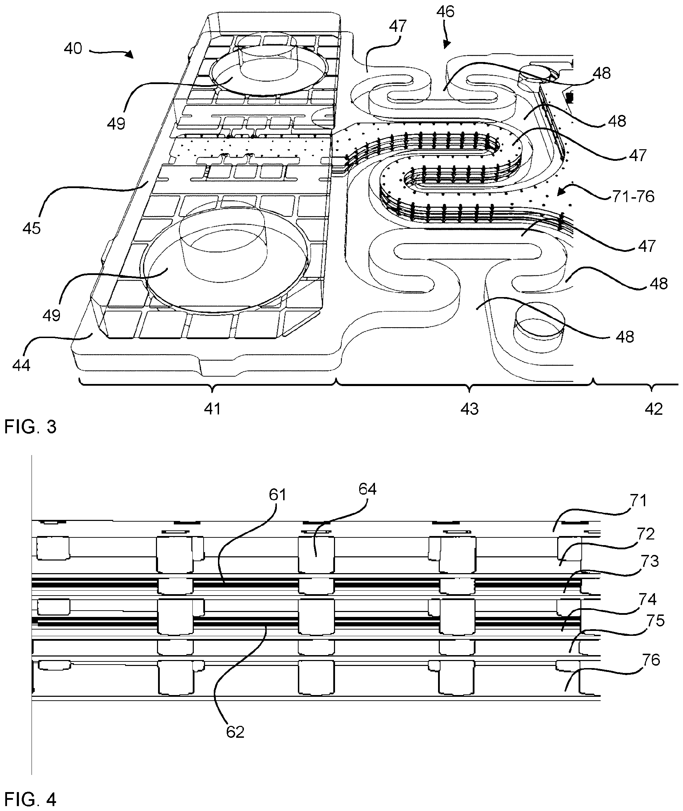

As shown in more detail in Figure 3, the first region 41 and the third region 43 also comprises an electric structure. Therein, the first region 41 comprises multiple surface metallizations that are electrically isolated from each other. Part of these surface metallizations form contact pads as described in more detail below, e.g. for solder pads for good mechanical attachment of the shunt resistor 45 to the circuit carrier board 44 by the means of soldering. In the third region 43, the multi-layer structure of the circuit carrier board 44 is shown comprising a total of six carrier layers 71 to 76 laminated together and electrically isolated from each other. The electric isolation may be provided by additional insulation layers (not shown) in between the carrier layers 71 to 76. As shown in Fig. 3, a central meander-shaped structure 47 comprises the electric structure of the third region 43 with voltage paths and electric shielding means as described in detail below, wherein the two outer meander-shaped structures 47 perform solely mechanical functions. However, each of the three meander-shaped structures 47 contributes to the spring-like structure 46 between the first region 41 and the second region 42.

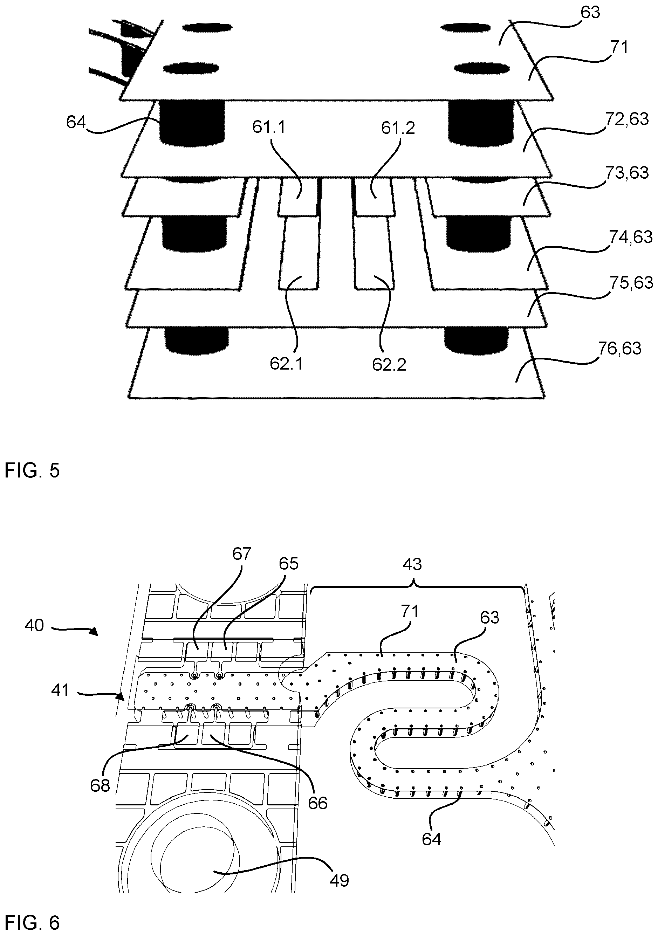

Figures 4 and 5 show detailed views of the layer structure of a circuit carrier 40, particularly the central meander-shaped structure 47 of the circuit carrier board 44 as illustrated in Figures 2 and 3. Therein, Figure 4 shows the full structures of the carrier layers 71 to 76, wherein Figure 5 solely illustrates the metallization on the respective carrier layers 71 to 76. As illustrated in Figure 4, at least in the central meander-shaped structure 47 of the third region 43, the circuit carrier board 44 comprises six carrier layers with four outer carrier layers 71, 72, 75, 76 and two inner carrier layers 73, 74. The carrier layers 71 to 76 are connected to each other via metal-filled via holes 64 that connect the carrier layers 71 to 76 in lateral regions thereof. The inner carrier layers 73, 74 comprise a voltage path 61 and a redundant voltage path 62, respectively, that are configured to conduct an electric current between the first region 41 and the second region 42, respectively. As shown in more detail in Figure 5, each of the outer carrier layers 71, 72, 75, 76 comprise a full surface metallization 63. These surface metallizations 63 function as electro-magnetic shielding means due to their polarizability. Further, the metallization 63 of the third carrier layer 73 and the fourth carrier layer 74 are partially removed in order to create a first voltage path 61.1 and a second voltage path 61.2 forming the voltage path 61 on the third carrier layer 73 and in order to create a third voltage path 62.1 and a fourth voltage path 62.2 on the fourth carrier layer 74. Further, the lateral remainders of the surface metallization 63 of the third and fourth carrier layer 73, 74 are electrically connected to the metallizations 63 of the outer carrier layers 71, 72, 75, 76 via the through hole vias 64, respectively, in order to contribute to the electromagnetic shielding.

Figures 6 to 9 illustrates further schematic perspective views of a circuit carrier 40 according to an embodiment, wherein in each of these Figures one of the carrier layers 71, 73, 74, and 76 is exposed. In Figure 6, the third region 43 of the circuit carrier 40 is shown with an exposed first carrier layer 71. Therein, the exposed first carrier layer 71 comprises a full metallization 63 as already described with respect to Figure 5. Further, upper ends of the plurality of vias 64 terminate in lateral regions of the first carrier layer 71. As further shown in Figure 6, in the first region 41 of the circuit carrier 40, a first shunt contact pad 65, a second shunt contact pad 66, a third shunt contact pad 67, and a fourth shunt contact pad 68 are formed. Each of these contact pads 65, 66, 67, 68 is electrically connected to one of the though-hole vias 64, respectively, wherein these vias 64 are separated and isolated from the metallization 63 of the first carrier layer 71. Other parts of the metallization within the first region 41 of the circuit carrier 40 that are surrounding these shunt contact pads 65, 66, 67, 68 are electrically connected to the metallization 63 of the first carrier layer 71 for contributing to the electrical shielding properties of the metallization 63 on the first carrier layer 71.

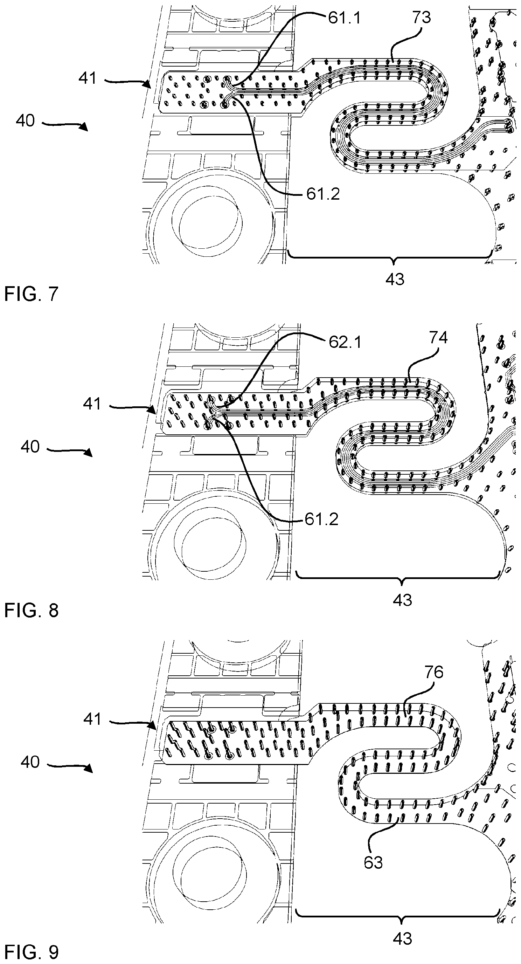

In Figure 7, the third region 43 of the circuit carrier 40 is shown with the exposed third carrier layer 73 comprising the first voltage path 61.1 and the second voltage path 61.2 as described with respect to Figure 5. Therein, the first voltage path 61.1 terminates in the first region 41 in the via that is connected to the first shunt contact pad 65 as shown in Figure 6 and the second voltage path 61.2 terminates in the first region 41 in the via that is connected to the second shunt contact pad 66 as shown in Figure 6. Hence, the voltage paths 61.1, 61.2 provide an electric connection between the shunt contact pads 65, 66 and an electronic circuit disposed in the second region 42 of the circuit carrier 40, respectively. This circuit preferably is a voltage measurement circuit and the voltage paths 61.1, 61.2 transport the voltage potential of the first and second shunt contact pad 65, 66 to the voltage measurement circuit, respectively. Thus, the voltage drop between the first and second shunt contact pad 65, 66 can be determined. Based on this voltage drop and on the known resistance of the shunt resistor 65, the electric current flowing through shunt resistor 45 can be determined. Hence, the current between the terminals that are disposed in the terminal openings 49, e.g., between cell terminals or module terminals of the battery system, can be determined.

In Figure 8, the third region 43 of the circuit carrier 40 is shown with the exposed fourth carrier layer 74, comprising the third voltage path 62.1 and the fourth voltage path 62.2 as described with respect to Figure 5. Therein, the third voltage path 62.1 terminates in the first region 41 in the via that is connected to the third shunt contact pad 67 as shown in Figure 6 and the fourth voltage path 62.2 terminates in the first region 41 in the via that is connected to the fourth shunt contact pad 68 as shown in Figure 6. Hence, the voltage paths 62.1, 62.2 provide an electric connection between the shunt contact pads 67, 68 and an electronic circuit disposed in the second region 42 of the circuit carrier 40, respectively. This circuit preferably is the voltage measurement circuit described above and the voltage paths 62.1, 62.2 provide a further voltage signal to this circuit in a redundant manner. Hence, measurement reliability and accuracy of the voltage measurement circuit as well as the determination of the current across the shunt resistor 45 as described above are improved.

Particularly, the voltage paths 62.1, 62.2 transport the voltage potential of the third and fourth shunt contact pad 67, 68 to the voltage measurement circuit, respectively. Thus, the voltage drop between the third and fourth shunt contact pad 67, 68 can be determined. Based on this voltage drop and based on the known resistance of the shunt resistor 65 the electric current flowing through shunt resistor 45 can be determined. Hence, the current between the terminals disposed in the terminal openings 49 can be determined redundantly.

In Figure 9, the third region 43 of the circuit carrier 40 is shown with the exposed sixth carrier layer 76. Therein, the exposed sixth carrier layer 76 also comprises a full metallization 63 as already described with respect to Figures 5 and 6. Lower ends of the plurality of vias 64 terminate in lateral regions of the sixth carrier layer 76. As further shown in Figure 9, the metallization 63 of the sixth layer 76 is separated and thus electrically isolated from the via that is connected to the first shunt contact pad 65 and from the via that is connected to the second shunt contact pad 66 as shown in Figure 6. The same holds true for the metallization 63 of the first carrier layer 71, as recognizable from Figure 6, as well as for the metallization 63 of the second and fifth carrier layer 72, 75 that are shown in Figure 5.

### Reference signs

- 30: cell supervision circuit carrier (prior art)
- 31: wiring harness (prior art)
- 32: connector (prior art)

- 40: circuit carrier
- 41: first region
- 42: second region
- 43: third region
- 44: circuit carrier board
- 45: shunt resistor
- 46: spring-like structure
- 47: meander-shaped structure
- 48: through opening
- 49: terminal opening

- 50: battery management system (BMS)
- 60: busbar

- 61: voltage path
- 61.1: first voltage path
- 61.2.: second voltage path
- 62: redundant voltage path
- 62.1: third voltage path
- 62.2: fourth voltage path
- 63: metallization
- 64: through-hole vias
- 65: first shunt contact pad
- 66: second shunt contact pad
- 67: third shunt contact pad
- 68: fourth shunt contact pad

- 71: first outer carrier layer
- 72: second outer carrier layer
- 73: third inner carrier layer
- 74: fourth inner carrier layer
- 75: fifth outer carrier layer
- 76: sixth outer carrier layer

- 90: battery module
- 100: battery system
- 101: positive system terminal
- 102: negative system terminal

## Claims

1. Battery cell supervision circuit carrier (40) configured to be mounted to a battery system (100) and comprising:
a shunt resistor (45) for performing shunt based current sensing,
a circuit carrier board (44) having a first region (41) and a second region (42), wherein the shunt resistor (45) is surface mounted in the first region (41), wherein a first shunt contact pad (65) and a second shunt contact pad (66) are disposed in the first region (41), and wherein the second region (42) is configured to receive further electronic components,
wherein the first region (41) and the second region (42) are separated from each other by a third region (43) configured for forming a flexible connection between the first region (41) and the second region (42) and comprising a spring-like structure (46) formed from the circuit carrier board (44),
wherein the circuit carrier board (44) is a multi-layer circuit carrier board (44) comprising at least three electrically isolated carrier layers (71, 72, 73, 74, 75, 76), providing at least one central voltage path layer that is enclosed via at least two outer layers that are configured for shielding said at least one voltage path,
wherein the at least three carrier layers (71, 72, 73, 74, 75, 76) comprise a metallization (63) within the third region (43) for said shielding purpose, wherein the metallization of the at least one inner carrier layer (73 ,74) is partially removed in order to create a first conductive path (61.1, 62.1) and a second conductive path (61.2, 62.2) forming the at least one voltage path (61, 62) on the at least third carrier layer (73,74),
wherein the lateral remainders of the surface metallization (63) of the at least one inner carrier layer (73 ,74) are electrically connected to the metallizations (63) of the outer carrier layers (71, 72, 75, 76) via through hole vias (64) in order to contribute to the electromagnetic shielding,
wherein said first conductive path (61.1, 62.1) is connected to the first shunt contact pad (65) and said second conductive path (61.2, 62.2) is connected to the second shunt contact pad (66).

2. Circuit carrier (40) according to claim 1, wherein the spring-like structure (46) comprises at least one meander-shaped structure (47) connecting the first region (41) and the second region (42), wherein the material of the remaining third region (43) is removed.

3. Circuit carrier (40) according to claim 1 or 2, wherein the spring-like structure (46) comprises a plurality of meander-shaped structures (47) separated from each other by at least one through-opening (48), and wherein the third region (43) consists of the meander-shaped structures (47) and the through openings (48).

4. Circuit carrier (40) according to any one of the preceding claims, wherein the spring like-structure (46) is formed by milling.

5. Circuit carrier (40) according to any one of the preceding claims, wherein the further electronic components comprise a voltage measurement circuit configured to be connected to the shunt resistor (45).

6. Circuit carrier (40) according to claim 5, wherein the at least one voltage path (61, 62) is configured for electrically connecting the shunt resistor (45) and the voltage measurement circuit and/or wherein the at least one voltage path (61, 62) is formed in or on the spring like structure (46).

7. Circuit carrier (40) according to claim 5 or 6, wherein the first conductive path (61.1) and second conductive path (61.2) are configured to be connected to the voltage measurement circuit.

8. Battery system (100) comprising a circuit carrier (40) according to any one of the claims 1 to 7 with the shunt resistor (45) being electrically connected to at least one current path of the battery system (100).

## Patentansprüche

1. Batteriezellen-Überwachungsschaltungsträger (40), der so konfiguriert ist, dass er an einem Batteriesystem (100) angebracht werden kann, und der Folgendes umfasst:
einen Shunt-Widerstand (45) zum Durchführen von Shunt-basierter Stromerfassung,
eine Schaltungsträgerplatte (44) mit einem ersten Bereich (41) und einem zweiten Bereich (42), wobei der Shunt-Widerstand (45) in dem ersten Bereich (41) oberflächenmontiert ist, wobei ein erstes Shunt-Kontaktfeld (65) und ein zweites Shunt-Kontaktfeld (66) in dem ersten Bereich (41) angeordnet sind, und wobei der zweite Bereich (42) zur Aufnahme weiterer elektronischer Komponenten konfiguriert ist,
wobei der erste Bereich (41) und der zweite Bereich (42) durch einen dritten Bereich (43) voneinander getrennt sind, der zum Bilden einer flexiblen Verbindung zwischen dem ersten Bereich (41) und dem zweiten Bereich (42) konfiguriert ist und eine federartige Struktur (46) umfasst, die aus der Schaltungsträgerplatte (44) gebildet ist,
wobei die Schaltungsträgerplatte (44) eine mehrschichtige Schaltungsträgerplatte (44) ist, die mindestens drei elektrisch isolierte Trägerschichten (71, 72, 73, 74, 75, 76) umfasst, die mindestens eine zentrale Spannungspfadschicht bereitstellen, die über mindestens zwei äußere Schichten eingeschlossen ist, die zum Abschirmen des mindestens einen Spannungspfads konfiguriert sind,
wobei die mindestens drei Trägerschichten (71, 72, 73, 74, 75, 76) eine Metallisierung (63) innerhalb des dritten Bereichs (43) für den Abschirmungszweck aufweisen, wobei die Metallisierung der mindestens einen inneren Trägerschicht (73, 74) teilweise entfernt wird, um einen ersten leitenden Pfad (61.1, 62.1) und einen zweiten leitenden Pfad (61.2, 62.2) zu erzeugen, die den mindestens einen Spannungspfad (61, 62) auf der mindestens dritten Trägerschicht (73, 74) bilden,
wobei die seitlichen Reste der Oberflächenmetallisierung (63) der mindestens einen inneren Trägerschicht (73, 74) mit den Metallisierungen (63) der äußeren Trägerschichten (71, 72, 75, 76) über Durchkontaktierungen (64) elektrisch verbunden sind, um zur elektromagnetischen Abschirmung beizutragen,
wobei der besagte erste leitende Pfad (61.1, 62.1) mit dem ersten Shunt-Kontaktfeld (65) verbunden ist und der besagte zweite leitende Pfad (61.2, 62.2) mit dem zweiten Shunt-Kontaktfeld (66) verbunden ist.

2. Schaltungsträger (40) nach Anspruch 1, wobei die federartige Struktur (46) mindestens eine mäanderförmige Struktur (47) aufweist, die den ersten Bereich (41) und den zweiten Bereich (42) verbindet, wobei das Material des verbleibenden dritten Bereichs (43) entfernt wird.

3. Schaltungsträger (40) nach Anspruch 1 oder 2, wobei die federartige Struktur (46) eine Vielzahl von mäanderförmigen Strukturen (47) aufweist, die durch mindestens eine Durchgangsöffnung (48) voneinander getrennt sind, und wobei der dritte Bereich (43) aus den mäanderförmigen Strukturen (47) und den Durchgangsöffnungen (48) besteht.

4. Schaltungsträger (40) nach einem der vorhergehenden Ansprüche, wobei die federartige Struktur (46) durch Fräsen gebildet wird.

5. Schaltungsträger (40) nach einem der vorhergehenden Ansprüche, wobei die weiteren elektronischen Komponenten eine Spannungsmessschaltung umfassen, die zum Anschluss an den Shunt-Widerstand (45) ausgebildet ist.

6. Schaltungsträger (40) nach Anspruch 5, wobei der mindestens eine Spannungspfad (61, 62) zum elektrischen Verbinden des Shunt-Widerstands (45) und der Spannungsmessschaltung ausgebildet ist und/oder wobei der mindestens eine Spannungspfad (61, 62) in oder auf der federartigen Struktur (46) ausgebildet ist.

7. Schaltungsträger (40) nach Anspruch 5 oder 6, wobei der erste Leitungspfad (61.1) und der zweite Leitungspfad (61.2) so konfiguriert sind, dass sie mit der Spannungsmessschaltung verbunden sind.

8. Batteriesystem (100), umfassend einen Schaltungsträger (40) nach einem der Ansprüche 1 bis 7, wobei der Shunt-Widerstand (45) mit mindestens einem Strompfad des Batteriesystems (100) elektrisch verbunden ist.

## Revendications

1. Support de circuit de supervision de cellule de batterie (40) configuré pour être monté sur un système de batterie (100) et comprenant :
une résistance de dérivation (45) pour réaliser une détection de courant basée sur une dérivation,
une carte de support de circuit (44) ayant une première région (41) et une deuxième région (42), dans lequel la résistance de dérivation (45) est montée en surface dans la première région (41), dans lequel une première plage de contact de dérivation (65) et une deuxième plage de contact de dérivation (66) sont disposées dans la première région (41), et dans lequel la deuxième région (42) est configurée pour recevoir d'autres composants électroniques,
dans lequel la première région (41) et la deuxième région (42) sont séparées l'une de l'autre par une troisième région (43) configurée pour former une connexion souple entre la première région (41) et la deuxième région (42) et comprenant une structure de type ressort (46) formée à partir de la carte de support de circuit (44),
dans lequel la carte de support de circuit (44) est une carte de support de circuit multicouche (44) comprenant au moins trois couches de support électriquement isolées (71, 72, 73, 74, 75, 76), fournissant au moins une couche centrale de chemin de tension qui est entourée par au moins deux couches externes qui sont configurées pour protéger ledit au moins un chemin de tension,
dans lequel les au moins trois couches de support (71, 72, 73, 74, 75, 76) comprennent une métallisation (63) à l'intérieur de la troisième région (43) à des fins de protection, dans lequel la métallisation de l'au moins une couche de support interne (73, 74) est partiellement retirée afin de créer un premier chemin conducteur (61.1, 62.1) et un deuxième chemin conducteur (61.2, 62.2) formant l'au moins un chemin de tension (61, 62) sur l'au moins une troisième couche de support (73, 74),
dans lequel les restes latéraux de la métallisation de surface (63) de l'au moins une couche de support interne (73, 74) sont électriquement connectés aux métallisations (63) des couches de support externes (71, 72, 75, 76) à travers des trous de raccordement traversants (64) afin de contribuer à la protection électromagnétique,
dans lequel ledit premier chemin conducteur (61.1, 62.1) est connecté à la première plage de contact de dérivation (65) et ledit deuxième chemin conducteur (61.2, 62.2) est connecté à la deuxième plage de contact de dérivation (66).

2. Support de circuit (40) selon la revendication 1, dans lequel la structure de type ressort (46) comprend au moins une structure en forme de méandre (47) connectant la première région (41) et la deuxième région (42), dans lequel le matériau de la troisième région restante (43) est éliminé.

3. Support de circuit (40) selon la revendication 1 ou 2, dans lequel la structure de type ressort (46) comprend une pluralité de structures en forme de méandre (47) séparées les unes des autres par au moins une ouverture traversante (48), et dans lequel la troisième région (43) est constituée des structures en forme de méandre (47) et des ouvertures traversantes (48).

4. Support de circuit (40) selon l'une quelconque des revendications précédentes, dans lequel la structure de type ressort (48) est formée par fraisage.

5. Support de circuit (40) selon l'une quelconque des revendications précédentes, dans lequel les autres composants électroniques comprennent un circuit de mesure de tension configuré pour être connecté à la résistance de dérivation (45).

6. Support de circuit (40) selon la revendication 5, dans lequel l'au moins un chemin de tension (61, 62) est configuré pour connecter électriquement la résistance de dérivation (45) et le circuit de mesure de tension et/ou dans lequel l'au moins un chemin de tension (61, 62) est formé dans ou sur la structure de type ressort (46).

7. Support de circuit (40) selon la revendication 5 ou 6, dans lequel le premier chemin conducteur (61.1) et le deuxième chemin conducteur (61.2) sont configurés pour être connectés au circuit de mesure de tension.

8. Système de batterie (100) comprenant un support de circuit (40) selon l'une quelconque des revendications 1 à 7, avec la résistance de dérivation (45) étant connectée électriquement à au moins un chemin de courant du système de batterie (100).
